Europäisches Patentamt

European Patent Office

Office européen des brevets

(11) Publication number: **0 340 918**
**A2**

## (12) EUROPEAN PATENT APPLICATION

(21) Application number: **89303445.4**

(22) Date of filing: **07.04.89**

(51) Int. Cl.⁴: **H03K 17/08 , H03K 17/16**

(30) Priority: **06.05.88 GB 8810750**

(43) Date of publication of application:
**08.11.89 Bulletin 89/45**

(84) Designated Contracting States:
**BE DE ES FR GB IT SE**

(71) Applicant: **SALPLEX LIMITED**
**Boughton Road**
**Rugby Warwickshire CV21 1BU(GB)**

(72) Inventor: **Greenwood, Jeremy John**
**269 Boldmere Road Boldmere Sutton**
**Coldfield**
**West Midlands England(GB)**

(74) Representative: **Sperling, David**
**Central Patent Dept. (Wembley Office) The**
**General Electric Company plc Hirst**
**Research Centre East Lane**
**Wembley Middlesex HA9 7PP(GB)**

(54) Mosfet power switch arrangements.

(57) A power MOSFET (1) has a thyristor (2) connected across the gate (G) and source (S) electrodes and thermally connected to the MOSFET (1). With the MOSFET (1) on and a load (3) in normal condition the thyristor (2) is off. If the load (3) goes short-circuit then the thyristor (2) will turn on above a predetermined temperature and cause the MOSFET (1) to turn off. Voltage transients will be generated by parasitic wiring inductances (7,8) in the power feeds to the drain (D) and source (S) electrodes when the thyristor (2) turns on. A zener diode (12) and rectifying diode (11) in series between the drain (D) and gate (G) electrodes and a resistance (10) in series with the thyristor (2) suppress these voltage transients by keeping the drain-gate and drain-source voltages within safe limits, while allowing the transient energy to dissipate by current conduction through the MOSFET with the turn-off time being no longer than is necessary for the particular values of the parasitic inductances (7,8).

Fig.4.

Fig.5.

# MOSFET power switch arrangements.

This invention relates to MOSFET power switch arrangements and in particular to such an arrangement including a MOSFET transistor and a semiconductor switch electrically connected to the gate electrode of the MOSFET and thermally connected to the MOSFET, the arrangement being such that if the MOSFET is on and a load connected thereto is in normal condition then the semiconductor switch is off, such that if the MOSFET is on and the load is in short-circuit condition the heat generated in the MOSFET causes the semiconductor switch to turn on when it goes above a predetermined temperature, and such that the turned on condition of the semiconductor switch causes the MOSFET to turn off, the arrangement also including means for suppressing voltage transients generated by parasitic wiring inductances in the power feeds to the MOSFET drain and source electrodes when it turns off responsive to the semiconductor switch turning on.

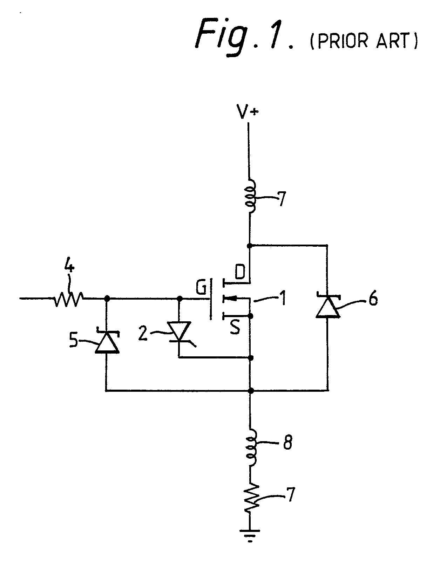

An arrangement in accordance with the above description is shown in Figure 1 of the accompanying drawings. A semiconductor device having a MOSFET transistor such as the MOSFET 1 with a semiconductor switch such as the thyristor 2 thermally connected to the MOSFET 1 and the two main electrodes of the thyristor 2 connected across the gate G and source S electrodes of the MOSFET is known from Patent Document EP 208970A. The thyristor 2 is designed to turn on before a temperature, which may be between 130 and 180° C, critical for the MOSFET 1 is reached. This uses the previously known failure mode of triacs and thyristors, that they will turn on above a certain temperature, in order to provide temperature protection for a MOSFET transistor. In the event of a temperature being reached which is potentially damaging for the MOSFET 1, the thyristor 2 turns on and causes the MOSFET 1 to turn off by reducing the gate-source voltage below its threshold value. This has the advantage of protecting the MOSFET against overload conditions of excessive current or an inadequate thermal environment while allowing it to exploit all specified combinations of power dissipation and ambient temperature. In particular, if the MOSFET 1 is on and a load 3 connected thereto is in normal condition then the thyristor 2 is off, whereas if the MOSFET 1 is on and the load 3 is in short-circuit condition then the heat generated in the MOSFET 1 causes the thyristor 2 to turn on above a predetermined temperature and the turned on condition of the thyristor 2 causes the MOSFET 1 to turn off.

An application of the combined MOSFET 1 and the thyristor 2 device in which a control signal is applied to the gate of the MOSFET via a resistor 4 and is limited by a zener diode 5, and in which a zener diode 6 is connected across the MOSFET drain D and source S electrodes as shown in Figure 1 is known from the device literature "Announcing SMART SIPMOS" published by Siemens in 1986, for example from the data sheet given for device BTS 130. In the event of the load 3 being in short-circuit condition, a high short-circuit current will flow through the MOSFET 1 whose value is determined by the transconductance of the MOSFET 1 and the zener voltage of the zener diode 5. With a typical 8 volt zener diode 5, the short-circuit current through the MOSFET 1 is typically 80 amps. When the heat generated by this high short-circuit current causes the thyristor 2 to turn on, the gate-source voltage of the MOSFET 1 falls rapidly to a low value and the drain-source current of the MOSFET is blocked. There will be parasitic wiring inductances 7,8 in the power feeds to the MOSFET drain and source electrodes. Due to the inherent high switching speed of the MOSFET 1, the turn-off speed of the MOSFET 1 responsive to the thyristor 2 turning on will be high and voltage transients generated by the parasitic inductances 7,8 when the drain-source current of the MOSFET is blocked can be high enough to cause catastrophic and permanent damage to the MOSFET 1 if they are not suppressed. Typically the drain-source voltage of the MOSFET 1 must be kept to less than 50 volts to avoid damage. The zener diode 6 provides the necessary voltage transient suppression by providing an alternative current path for dissipation of the transient energy while limiting the transient drain-source voltage and hence also the transient drain-gate voltage.

A disadvantage of the known arrangement described above with reference to Figure 1 is that the zener diode 6 needs to be a large and expensive power device because it is required to have a low slope resistance, that is to say that it has to conduct the initial high short-circuit current of typically 80A without this producing a voltage rise from its nominal zener voltage sufficient to over-rate the MOSFET drain-source or drain-gate junctions. The amount of transient energy generated by the parasitic wiring inductances 7,8 and hence the time taken for it to dissipate through the zener diode 6 depends on the size of these inductances. In a practical application there may be long lengths of system wiring, as well as circuit board tracking in the near environment of the MOSFET device, and the actual leads of the MOSFET device itself which all contribute to the parasitic wiring inductances 7 and 8. For most of such system wiring there may be compensating capacitances, but the remaining parasitic wiring inductances due to the near environment and the leads of the device itself will still need to be suppressed by the zener diode 6. Even if these remaining parasitic inductances are small and produce only a small energy transient, the zener diode 6 will still need to be a large and expensive power device in order to provide voltage suppression when initially carrying the high short-circuit current whose passage through the MOSFET has been blocked. Apart from its expense, the large size of the zener diode 6 is itself a problem since this makes it difficult to mount it close to the MOSFET device. If it is not mounted close enough and the zener diode leads are of significant length then their parasitic inductance will delay the current build up in the zener diode possibly sufficient to allow a significant voltage surge on the MOSFET.

An automotive vehicle electrical system is an example of a system in which power MOSFET transistors may be advantageously temperature protected each by a semiconductor switch as described above, but in which the disadvantageous expense of using a power zener diode in each case to suppress the voltage transients arising from the action of the semiconductor switch can be significant. One such system is known from the article "Multiplexing for the automotive industry" by W.R.Betts in GEC REVIEW, Vol.2, No.1, 1986 at pages 32 to 36. In the system described in this article a central master unit including a microcomputer is connected by low current signalling links in a star wired arrangement to a number of remote, non-intelligent, slave units. Manually operable switches, sensors and high current loads are connected to the slave units and their interaction is controlled from the master unit by means of time slot assignment multiplex. In particular, remote switching of power MOSFETs in the slave units controls the high current loads connected to them. Such a system could, for example, have approximately 20 slave units each with 16 time multiplexed channels nearly half of which have a load connected to them. Thus over 100 power MOSFETs can be used in such a system and, if each power MOSFET is temperature protected by a semiconductor switch as described above with a power zener diode for voltage transient protection as described above, then the temperature and voltage transient protected MOSFETs can account for approximately half the total electronics cost of the system with the power zener diodes accounting for approximately one tenth of this total electronics cost.

An object of the invention is to provide an alternative means for suppressing voltage transients associated with the power MOSFET temperature protection action of the semiconductor switch as described above, which alternative avoids the use of an expensive and large power zener diode as described above.

According to the invention there is provided a MOSFET power switch arrangement as described in the first paragraph of this specification, characterised in that the voltage transient suppression means inlcudes first suppression means for limiting to a predetermined value the drain-gate voltage due to the initial parasitically induced voltage excursion at the drain electrode when the semiconductor switch turns on, and second suppression means responsive to the initial parasitically induced voltage excursion at the source electrode when the semiconductor switch turns on to establish an initial gate-source voltage sufficient to keep the MOSFET on but not greater than a predetermined value, such that the voltage transient suppression means allows the transient energy to dissipate by current conduction through the MOSFET with the turn-off time of the MOSFET being dependent on the value of said parasitic wiring inductances.

In one preferred embodiment of the invention, the first suppression means includes a first zener diode and a rectifying diode coneted in series between the drain and gate electrodes, the second suppression means includes a second zener diode connected across the gate and source electrodes, and the second suppression means also includes the first suppression means together with a series combination of the semiconductor switch and a resistance, one end of said series combination being connected to the gate electrode and the other end of said series combination being connected in use to a reference voltage. In this case the MOSFET transistor, the first zener diode, the rectifying diode, the semiconductor switch and the resistance may all be within a power MOSFET device package having the usual three terminals for connection to the drain, gate and source electrodes and a fourth terminal for connection in use to said reference voltage. The second zener diode may also be within the power MOSFET device package.

In an alternative preferred embodiment of the invention, the just described arrangement is modified in that the other end of said series combination is connected to the source electrode. In this case the MOSFET transistor, the first zener diode, the rectifying diode, the semiconductor switch and the resistance may all be within a power MOSFET device package having the usual three terminals for connection to the drain, gate and source electrodes. In this case as well, the second zener diode may also be within the power MOSFET device package.

In the preferred embodiments described in the preceding two paragraphs, the resistance part of the series combination may be an inherent series resistance of the semiconductor switch.

In both preferred embodiments of the invention described above, the first zener diode and the series combination of the semiconductor switch and resistance provide two negative feedback mechanisms which combine to control the turn-off speed of the MOSFET. The first negative feedback mechanism is responsive to the parasitically induced voltage excursion at the drain electrode and the second negative feedback mechanism is responsive to the parasitically induced voltage excursion at the source electrode. Together these two mechanisms maintain the MOSFET on after the semiconductor switch has turned on, and they do so for an optimum time which is appropriate to whatever values the two parasitic inductances may have in any system in which the power MOSFET switch arrangement is incorporated. On the one hand the turn-off of the MOSFET will be sufficiently slow but no slower than is necessary to maintain the drain-gate voltage and the drain-source voltage at safe values however high the parasitic inductances may be. On the other hand the MOSFET is maintained on for as long but no longer than is necessary to dissipate the transient energy, so that if the parasitic inductances are low then the time for which the MOSFET remains at a potentially damaging high temperature is reduced accordingly.

In the arrangement according to the invention the energy of the voltage transient produced when the semiconductor switch turns on is allowed to dissipate in a controlled manner through the MOSFET itself, and so the prior art power zener diode is not required. The first zener diode in the preferred embodiments of the invention does not carry the high short-circuit switching current but only a small signal current which controls the MOSFET, so that this zener diode will be a small inexpensive device. The second zener diode in the preferred embodiments is that conventionally used to limit the gate-source voltage of the MOSFET in normal operation and is also a small inexpensive device.

An added advantage of the preferred embodiments of the invention is that they also protect the MOSFET against externally generated voltage transients which may occur when the MOSFET is off during normal operation. In particular, if a voltage spike is applied in such circumstancces to the drain electrode then the first zener diode will operate to limit the drain-gate voltage by raising the gate voltage to turn the MOSFET on and so dissipate the transient.

Another arrangement which would to some extent suppress voltage transients as an alternative to the prior art large power zener diode but which is unsatisfactory compared with the arrangement according to the invention is as follows. Referring again to Figure 1, a resistance having a specified value can be inserted in series with the semiconductor switch 2 between the gate and source electrodes or the inherent series resistance of the semiconductor switch 2 can be chosen to have this specified value. In conjunction with the inherent gate-source capacitance of the MOSFET transistor, this resistance will provide an RC time constant which increases the inherent turn-off time of the MOSFET to a particular value and allows voltage transient energy due to the two parasitic wiring inductances to dissipate through the MOSFET during this RC turn-off time. However, it cannot be known what the actual values of the MOSFET gate-source capacitance and the two parasitic wiring inductances will be in any particular case. Thus the value chosen for the resistance would have to be large enough to provide in conjunction with the lowest expected gate-source capacitance a turn-off time large enough safely to suppress the transient drain and source voltage excursions due to the highest expected parasitic wiring inductances. The turn-off time of the MOSFET will thus always have to be longer than is absolutely necessary for suppression of the voltage transient, and so the MOSFET will continue to conduct and be at a potentially damaging high temperature for longer than is necessary after the semiconductor switch turns on. Furthermore, this arrangemnt would not protect the MOSFET against externally generated voltage transients when the MOSFET is off during normal operation and a zener diode might need to be provided across the drain and source electrodes to give this protection.

The two preferred embodiments of the invention will now be described in detail with reference to Figures 2 to 5 of the accompanying drawings, in which:-

Figures 2 and 4 respectively show the circuit arrangement of the first and second embodiments, and

Figures 3 and 5 respectively show waveforms illustrating the operation of the embodiments of Figures 2 and 4.

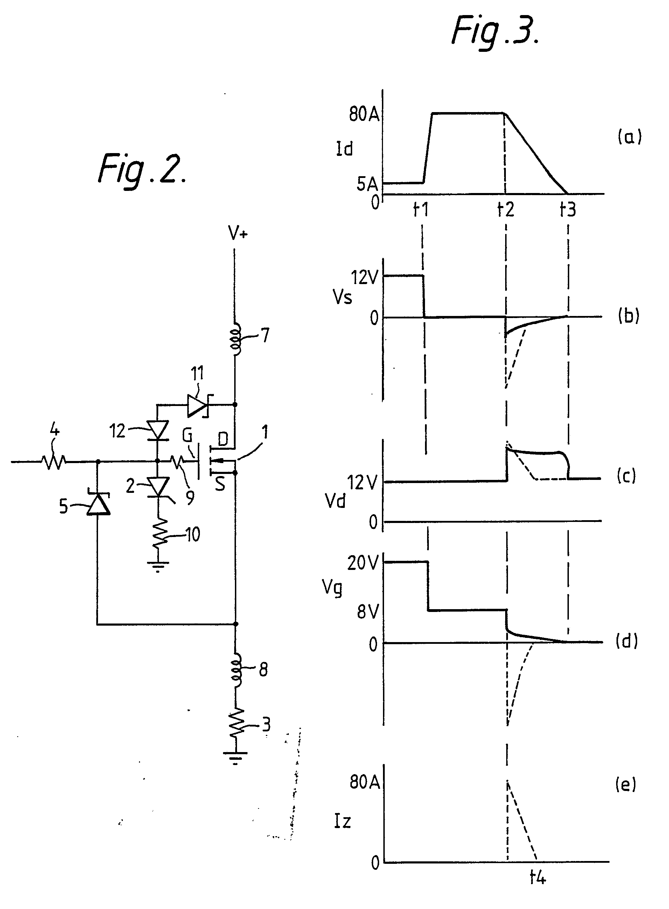

Referring now to Figure 2, those parts of the arrangment which are the same as in the prior art arrangment shown in Figure 1 are given the same reference numerals. The power MOSFET switch arrangement shown has a semiconductor device having a power MOSFET transistor 1 with a semiconductor switch in the form of a thyristor 2 thermally connected to the MOSFET 1 and the two main electrodes of the thyristor 2 connected across the gate G and source S electrodes. A high current load 3 is connected between the MOSFET source S and a ground connection, and the MOSFET drain D is connected to a positive potential +V volts. In normal operation a control signal is applied to the gate G of the MOSFET via a resistor 4 and is limited by a zener diode 5. The control signal turns the power MOSFET 1 on and off to operate the high current load 3. If the MOSFET 1 is on and the load 3 is in normal condition then the thyristor 2 is off, whereas if the MOSFET 1 is on and the load 3 is in short-circuit condition then the heat generated in the MOSFET 1 causes the thyristor 2 to turn on above a predetermined temperature of say 150°C and the turned on condition of the thyristor 2 causes the gate-source voltage to fall whereby the drain-source current is blocked and the MOSFET 1 is turned off and thus protected from damage which would occur if it remained at that predetermined temperature.

One main electrode of the thyristor 2 is connected to the gate electrode G, optionally via a low value resistance 9 whose function will be explained later. The other main electrode of the thyristor 2 is connected via a resistance 10 to a ground connection. A zener diode 11 and a rectifying diode 12 are connected in series between the drain D and gate G electrodes. There will be parasitic wiring inductances 7,8 in the power feeds to the MOSFET drain and source electrodes. The zener diode 11, rectifying diode 12, thyristor 2 and resistance 10, together with the zener diode 5, provide means for suppressing voltage transients generated by the parasitic inductances 7,8 when the MOSFET 1 turns off responsive to the thyristor 2 turning on. The zener diode 11 and the rectifying diode 12 form first suppression means for limiting to a predetermined value the drain-gate voltage due to the initial parasitically induced voltage excursion at the drain electrode D when the thyristor 2 turns on. Also the zener diode 11, rectifying diode 12, thyristor 2 and resistance 10, together with the zener diode 5, form second suppression means responsive to the initial parasitically induced voltage excursion at the source electrode S when the thyristor 2 turns on to establish an initial gate-source voltage sufficient to keep the MOSFET on but not greater than a predetermined value. The first and second suppression means allows the voltage transient energy generated by the parasitic wiring inductances 7,8 to dissipate the current conduction through the MOSFET with the turn-off time of the MOSFET being dependent on the values of the inductances 7,8.

The semiconductor switch 2 may be a triac instead of a thyristor. The resistance 10 may be an inherent series resistance of the semiconductor switch 2. The MOSFET transistor 1 and thyristor 2 together with the optional resistance 9, the zener diode 11, rectifying diode 12, and the resistance 10 may all be within a power MOSFET device package having the usual three terminals for connection to the drain, gate and source electrodes with an additional fourth terminal for connection of the resistance 10 to ground potential.

The operation of the arrangement shown in Figure 2 will now be explained with reference to the waveforms shown in Figure 3. The full line waveforms of graphs (a), (b), (c) and (d) respectively show the current Id through the MOSFET 1, and the voltages Vs at its source electrode, Vd at its drain electrode and Vg at its gate electrode from an initial time when the MOSFET is on with the load 3 in normal condition, through time t1 when the load 3 goes to short-circuit condition, through time t2 when the thyristor 2 turns on, to time t3 when the MOSFET turns off. The dotted line waveforms on graphs (a), (b), (c) and (d) and the waveform on graph (e) show the operation of the prior art arrangement of Figure 1 for comparison.

Initially with the MOSFET 1 and the load 3 in normal condition, the drain voltage Vd and source voltage Vs will both be approximately at the potential +V, the gate voltage Vg will be at a high value determined by the zener diode 5, the rectifying diode 12 will ensure that the zener diode 11 does not conduct in its forward direction, the thyristor 2 will be turned off and current will not flow through the resistance 10, and the current Id through the MOSFET 1 will be determined by the resistance of the load 3. For example, in an automotive vehicle electrical system the potential +V may be the battery voltage 12 volts and the load 3 may be a headlamp bulb. In this case initially both Vd and Vs will be approximately at 12 volts with the drain-source voltage Vds approximately 0.5 volts, Vg may be at 20 volts and Id may be 5 amps. When the load 3 goes to short-circuit condition at time t2 the source voltage Vs drops to ground potential at 0 volts, the gate voltage Vg accordingly drops to 8 volts as determined by the zener diode 5, and the current Id rises to a short-circuit value determined by the transconductance of the MOSFET 1 and the zener voltage of the zener diode 5. The short-circuit value of the current Id after time t1 may typically be 80 amps. The heat generated by this high short-circuit current through the MOSFET 1 raises its temperature and hence also raises the temperature of the thermally connected thyristor 2 until at time t2 the thyristor 2 goes above a predetermined temperature of, for example, 150°C which causes it to turn on. The thyristor 2 turning on at time t2 causes the gate voltage Vg to drop towards 0V. However, the drain-source current Id is not immediately blocked, owing to the parasitic wiring inductances 7,8 which respectively cause an initial positive excursion of the drain voltage Vd and an initial negative excursion of the source voltage Vs, and owing to the action of the means for suppressing these voltage excursions provided in the arrangement of Figure 2. The possible extent of these two voltage excursions if they were not suppressed would depend on the value of the respective parasitic wiring inductances 7,8 but they would be in practice about the same and, due to the inherent high switching speed of the power MOSFET 1, they would be high enough to cause the drain-gate voltage Vdg and drain-source voltage Vds to go to values high enough to cause catastrophic damage to the MOSFET 1.

If the prior art power zener diode 6 as shown in Figure 1 were present then, as shown by the dotted line waveforms, the initially induced voltage excursions at the drain and source electrodes at time t2 would be limited by the zener voltage of the zener diode 6 to ensure a safe value of the drain-source voltage Vds, for example 50 volts. The actual values of the excursions of Vd and Vs would depend on the relative values of the inductances 7,8 but in practice would be about the same, for example 19 volts each way with Vd going initially to +31 volts and Vs going initially to -19 volts, The gate voltage Vg in the arrangement of Figure 1 would follow the source voltage Vs from time t2. In this prior art arrangement of Figure 1, the MOSFET current Id would fall rapidly to zero at the time t2 and the zener diode 6 would provide an alternative path for the blocked MOSFET current, the zener diode current Iz starting at the short-circuit current value at time t2. As the transient energy dissipates by current conduction through the zener diode 6, the current Iz would reduce to zero at a time t4 at which time the MOSFET drain voltage Vd would reach 12 volts, and the source and gate voltages Vs and Vg would reach 0 volts.

In the arrangement as shown in Figure 2, the zener voltage of the zener diode 12 is chosen to be a value which will in practice always be reached due to the positive induced excursion of the drain voltage Vd at time t2, will ensure a safe value for the drain-gate voltage Vdg at that time and will also help to ensure a safe value for the drain-source voltage Vds. This zener voltage may be, for example, 20 volts. At time t2 the gate voltage will be held a little above 0 volts partly by the tendency of the drain voltage Vd to go above 42 volts. The negative excursion of the source voltage Vs at time t2 will, by means of the resistance 10, establish a gate-source voltage Vgs which will exceed the threshold gate-source voltage so as to keep the MOSFET on and thereby limit that negative excursion of the source votage Vs. At the time t2 the gate voltage will be held a little above 0 volts also partly by the resistance 10. The gate-source voltage Vgs at time t2 will not exceed the zener voltage of the zener diode 5, for example 8 volts as previously mentioned, so that an absolute safe limit for the drain-source voltage at time t2 is set by the combined zener voltages of zener diodes 11 and 5, for example 38 volts. The actual value of the gate-source voltage established at time t2 depends on the current which is passed by the zener diode 11 through the resistance 10 and the value of the resistance 10. This signal current, which controls the MOSFET from time t2, may be for example 5mA such that for a resistance 10 of, for example, 1Kohm, a gate-source voltage Vgs of 5 volts is established at time t2. The limitation of the positive excursion of the drain voltage Vd and the limitation of the negative excursion of the source voltage Vs at the time t2 may each be considered as by operation of a respective negative feedback mechanism. At time t2 the current Id through the MOSFET 1 is initially maintained at its short-circuit value and then, as the energy of the voltage transients generated by the parasitic inductances 7,8 dissipates by current conduction through the MOSFET, the current Id falls at a rate determined by the particular values of the inductances 7,8 to zero at time t3. From time t2 the source voltage Vs rises quickly from its negative excursion limit, of for example, nearly -5 volts, back to 0 volts at time t3, the drain voltage Vd drops slowly from its positive excursion limit until nearly time t3 when it then drops to 12 volts, and the gate voltage Vg drops slowly from just above 0 volts to 0 volts at time t3.

The action of the low resistance 9 is to reduce any tendency to oscillation between times t2 and t3 due to any parasitic capacitance, for example in the zener diode 11 and rectifying diode 12.

It may be noted that the arrangement of Figure 2 will also protect the MOSFET 1 against externally generated voltage transients which may occur when the MOSFET is off during normal operation. In particular, if a voltage spike is applied in such circumstances to the drain electrode then the zener diode 11 will operate to limit the drain-gate voltage by raising the gate voltage to turn the MOSFET on and so dissipate the transient. A voltage spike applied in the same circumstances to the source electrode would in any case be suppressed by turning the MOSFET on.

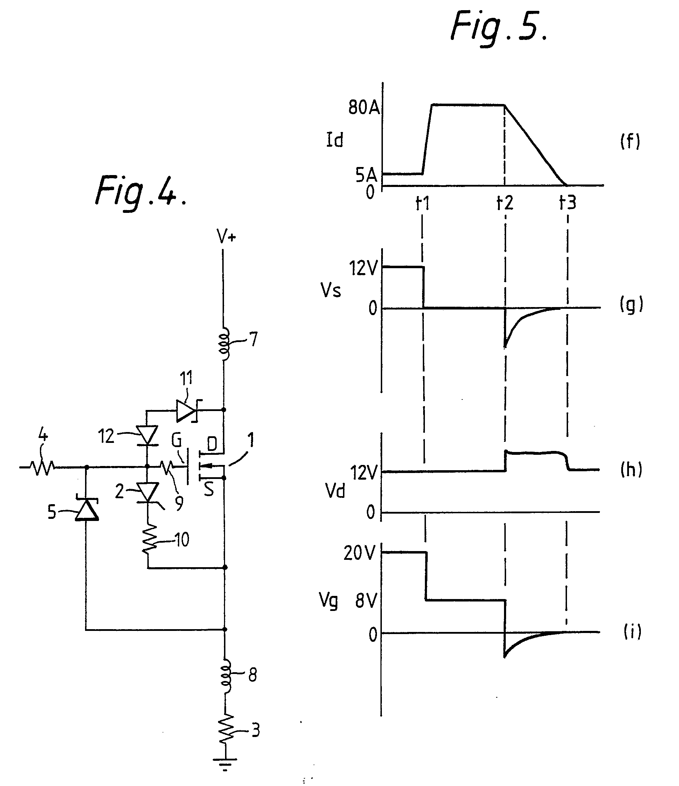

The ground connection of one end of the resistance 10 in the arrangement of Figure 2 may be considered as a reference voltage connection. The transient voltage excursions of the drain and source electrodes as shown in Figure 3 may be considered as occuring relative to this reference voltage of 0 volts. However, for protection of the MOSFET it is not the absolute voltages of the three electrodes relative to 0 volts which is in itself important but rather the potentials of these electrodes relative to each other having regard to safe values for the drain-gate voltage and the drain-source voltage. This consideration leads to the possibility of the alternative arrangement shown in Figure 4.

Referring now to Figure 4, the arrangement is the same as that shown in Figure 2 with the modification that the end of the resistance 10 away form the gate electrode G is connected to the source electrode S. The operation of the arrangement shown in Figure 4 is essentially the same as the Figure 2 arrangement in its suppression of the drain and source voltage excursions when the thyristor 2 turns on, so as to limit the drain-gate and drain-source voltages to safe values while transient energy due to the parasitic inductances 7,8 is dissipated by current conduction through the MOSFET with a turn-off time determined by these inductances.

Referring now to Figure 5, the waveforms (f), (g), (h) and (i) show the current Id and the voltages Vs, Vd and Vg for the Figure 4 arrangement through the times t1, t2 to t3 which respectively indicate the load 3 going short-circuit, the thyristor 2 turning on and the MOSFET 1 turning off in the same manner as for Figure 3. The waveform (f) for the current Id is the same as the waveform (a) shown in Figure 3. The waveforms for the source, drain and gate voltages Vs, Vd and Vg up to the time t2 when the thyristor 2 turns on are the same as shown in Figure 3. From time t2 to time t3 the arrangement of Figure 4 controls the voltages Vs, Vd and Vg in a similar manner to the arrangement of Figure 2 except that instead of these three voltages being controlled relative to 0 volts as a reference it is rather the case that the drain voltage Vd and the gate voltage Vg are controlled relative to the source voltage Vs as a reference. Thus at time t2 the drain voltage Vd goes positive above 12 volts responsive to the parasitic inductance 7, the source voltage Vs goes negative below 0 volts responsive to the parasitic inductance 8 and the gate voltage Vg follows the source voltage below 0 volts. The respective positive and negative excursions of Vd and Vg are limited by the drain-gate voltage reaching the zener voltage of the zener diode 11 and the negative excursion of Vs is limited by the gate-source voltage Vgs exceeding the threshold voltage to keep the MOSFET 1 on. For a circuit arrangement of Figure 4 having the same component values as the circuit arrangement of Figure 2 the limiting values of the drain-gate voltage Vdg, gate-source voltage Vgs and drain-source voltage Vds at the time t2 will be the same as for the arrangement of Figure 2. However, compared with the Figure 2 arrangement, in the Figure 4 arrangement Vd will go less positive and Vs will go more negative. As shown in Figure 5, from time t2 the source voltage Vs rises quickly from its negative excursion limit back to 0 volts at time t3, the drain voltage Vd drops slowly from its positive excursion limit until nearly time t3 when it drops to 12 volts, and the gate voltage Vg rises from its negative excursion limit with approximately the same characteristic as Vs until it reaches 0 voltage at time t3.

A possible disadvantage of the arrangement of Figure 4 is that the voltage transient is applied, at a reduced level, to the resistor 4 and its associated circuitry because the gate voltage Vg is allowed to go negative by an undefined amount according to the value of the parasitic inductance 8. However, the significant advantage of the Figure 4 arrangement is that the MOSFET transistor 1 and thyristor 2 together with the optional resistance 9, the zener diode 11, rectifying diode 12, and the resistance 10 may all be within a standard power MOSFET device package having only the usual three terminals for connection to the drain, gate and source electrodes.

The arrangements of Figure 2 and Figure 4 show a load 3 connected to the source electrode of the MOSFET transistor 1. These arrangements would work equally well if the load were instead connected to the drain electrode of the MOSFET. In this case, for both arrangements, Vs and Vd would both be at approximately 0 volts and Vg would be at 8 volts before time t1. When the load connected to the drain electrode goes short-circuit at time t1 Vd rises to 12 volts, and Vg and Vs remain respectively at 8 volts and 0 volts. From time t2 when the thyristor 2 turns on to time t3 when the MOSFET turns off, the voltages Vs, Vd and Vg would behave exactly as has been shown in Figures 3 and 5.

**Claims**

1. A MOSFET power switch arrangement including a MOSFET transistor (1) and a semiconductor switch (2) electrically connected to the gate electrode (G) of the MOSFET and thermally connected to the MOSFET, the arrangement being such that if the MOSFET is on and a load (3) connected thereto is in normal condition then the semiconductor switch (2) is off, such that if the MOSFET is on and the load (3) is in short-circuit condition the heat generated in the MOSFET causes the semiconductor switch (2) to turn on when it goes above a predetermined temperature, and such that the turned on condition of the semiconductor switch (2) causes the MOSFET to turn off, the arrangement also including means for suppressing voltage transients generated by parasitic wiring inductances (7,8) in the power feeds to the MOSFET drain (D) and source electrodes (S) when it turns off responsive to the semiconductor switch (2) turning on, characterised in that the voltage transient suppression means includes first suppression means (11,12) for limiting to a predetermined value the drain-gate voltage (Vdg) due to the initial parasitically induced voltage excursion at the drain electrode (D) when the semiconductor switch (2) turns on, and second suppression means (11,12,2,10,5) responsive to the initial parasitically induced voltage excursion at the source electrode (S) when the semiconductor switch (2) turns on to establish an initial gate-source voltage (Vgs) sufficient to keep the MOSFET (1) on but not greater than a predetermined value, such that the voltage transient suppression means allows the transient energy to dissipate by current conduction through the MOSFET with the turn-off time of the MOSFET being dependent on the values of said parasitic wiring inductances (7,8).

2. An arrangement as claimed in Claim 1, in which the first suppression means includes a first zener diode (11) and a rectifying diode (12) connected in series between the drain (D) and gate (G) electrodes, in which the second suppression means includes a second zener diode (5) connected across the gate (G) and source (S) electrodes, and in which the second suppression means also includes the first suppression means (11,12) together with a series combination of the semiconductor switch (2) and a resistance (10), one end of said series combination being connected to the gate (G) electrode and the other end of said series combination being connected in use to a reference voltage.

3. An arrangement as claimed in Claim 2, modified in that the other end of said series combination (2,10) is connected to the source (S) electrode.

4. An arrangement as claimed in Claim 2, in which the MOSFET transistor (1), the first zener diode (11), the rectifying diode (12), the semiconductor switch (2) and the resistance (10) are all within a power MOSFET device package having the usual three terminals for connection to the drain, gate and source electrodes and a fourth terminal for connection in use to said reference voltage.

5. An arrangement as claimed in Claim 3, in which the MOSFET transistor (1), the first zener diode (11), the rectifying diode (12), the semiconductor switch (2) and the resistance (10) are all within a power MOSFET device package having the usual three terminals for connection to the drain, gate and source electrodes.

6. An arrangement as claimed in Claim 4 or Claim 5, in which the second zener diode (5) is also within the power MOSFET device package.

7. An arrangement as claimed in any one of Claims 2 to 6, in which said resistance (10) is an inherent series resistance of the semiconductor switch (2).

8. An arrangement as claimed in any of Claims 1 to 7, in which the semiconductor switch (2) is a thyristor or a triac.

Fig.1. (PRIOR ART)

Fig.2.

Fig.3.

# Fig.4.

# Fig.5.